(19)

**Europäisches Patentamt**
**European Patent Office**
**Office européen des brevets**

(11) **EP 4 235 987 A1**

(12) **EUROPEAN PATENT APPLICATION**
published in accordance with Art. 153(4) EPC

(43) Date of publication:
**30.08.2023 Bulletin 2023/35**

(21) Application number: **22854451.6**

(22) Date of filing: **09.09.2022**

(51) International Patent Classification (IPC):
**H01S 5/40** (2006.01)   **H01S 5/02255** (2021.01)
**H01S 5/02315** (2021.01)   **H01S 5/02326** (2021.01)
**H01S 5/024** (2006.01)

(86) International application number:
**PCT/CN2022/118219**

(87) International publication number:
**WO 2023/134187 (20.07.2023 Gazette 2023/29)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.01.2022   CN 202210048123**

(71) Applicant: **Wuhan Raycus Fiber Laser
Technologies Co., Ltd
East Lake Hi-Tech Development Zone
Wuhan, Hubei 430000 (CN)**

(72) Inventors:
• **LI, Ning**
  **Wuhan, Hubei 430000 (CN)**

• **HU, Huixuan**
  **Wuhan, Hubei 430000 (CN)**
• **WANG, Ziwei**
  **Wuhan, Hubei 430000 (CN)**
• **WU, Mengdi**
  **Wuhan, Hubei 430000 (CN)**
• **LU, Kunzhong**
  **Wuhan, Hubei 430000 (CN)**
• **YAN, Dapeng**
  **Wuhan, Hubei 430000 (CN)**

(74) Representative: **Maiwald GmbH
Elisenhof
Elisenstraße 3
80335 München (DE)**

(54) **SEMICONDUCTOR LASER MODULE AND SEMICONDUCTOR LASER**

(57)   A semiconductor laser module and a semiconductor laser are provided by the present application, and include a heat sink base including a first plane and a second plane, laser chips arranged on the first plane to emit a first laser in a first direction, light beam reflectors arranged on the second plane for reflecting the first laser to form a second laser, light beam deflector configured to deflect the second laser to form a third laser in a second direction. The second direction is perpendicular to the first direction and perpendicular to a normal direction of the second plane.

FIG. 1

## Description

TECHNICAL FIELD

The present application relates to the technical field of a laser packaging, and in particular relates to a semiconductor laser module and a semiconductor laser.

BACKGROUND

In semiconductor lasers related technologies, adjacent COSs (chip on submount) are arranged in space by means of steps, and output power is increased by increasing the number of COSs.

SUMMARY

As the number of COSs increases, the number of steps will also increase, which will inevitably cause an overall height of a semiconductor laser to increase, greatly affecting a spatial size of an output module of the semiconductor laser.

In a first aspect, a semiconductor laser module is provided by an embodiment of the present application, including:

a heat sink base including a first plane and a second plane;
a plurality of laser chips arranged on the first plane, wherein the laser chips are configured to emit a first laser, and the first laser is propagated along a first direction;
a plurality of light beam reflectors arranged on the second plane, wherein the light beam reflectors correspond to the laser chips one-by-one, a normal direction of the second plane is perpendicular to the first direction, the light beam reflector includes a first reflective surface, an angle between a normal direction of the reflective surface and the normal direction of the second plane is a first included angle and the first included angle is an acute angle, and the first reflective surface is configured to reflect the first laser to form a second laser; and
a light beam deflector configured to deflect the second laser to form a third laser, wherein the third laser is propagated along a second direction, the second direction is perpendicular to the first direction, and the second direction is perpendicular to the normal direction of the second plane.

In a second aspect, a semiconductor laser is provided by an embodiment of the present application, including:

at least one optical path module, a second reflector, a focusing lens, and an optical fiber;
wherein the optical path module includes a semiconductor laser module, and the semiconductor laser module includes:

a heat sink base including a first plane and a second plane;
a plurality of laser chips arranged on the first plane, wherein the laser chip is configured to emit a first laser, and the first laser is propagated along a first direction; and
a plurality of light beam reflectors arranged on the second plane, wherein the beam reflectors correspond to the laser chips one-to-one, a normal direction of the second plane is perpendicular to the first direction, the beam reflector includes a first reflective surface, an angle between a normal direction of the first reflective surface and the normal direction of the second plane is a first included angle and the first included angle is an acute angle, and the first reflective surfaces are configured to reflect the first laser to form a second laser; and
a light beam deflector configured to deflect the second laser to form a third laser, wherein the third laser is propagated along a second direction, the second direction is perpendicular to the first direction, and the second direction is perpendicular to the normal direction of the second plane;
wherein the second reflector is configured to receive all laser emitted by the optical path module and reflect the laser to the focusing lens, the focusing lens is configured to focus all the laser to form a combined laser beam, and the combined laser beam enters the optical fiber and then outputs through the optical fiber.

In embodiments of the present application, the light beam reflector is arranged on the second plane in such a way that a normal line of the first reflective surface and a normal line of the second plane are at an acute angle, and the light beam deflector is provided so that the first laser is reflected by the first reflective surface to form the second laser, and the second laser is deflected by the light beam deflector to form the third laser light. The propagation direction of the third laser is perpendicular to the propagation direction of the first laser and the normal direction of the second plane, so as to realize a step-free spatial beam combination for the first laser. Compared with the semiconductor laser module in the related art that adopts step space beam combination, the spatial structure of the semiconductor laser module according to this application is more compact under a condition of outputting a same laser power.

BRIEF DESCRIPTION OF THE DRAWINGS

In order to more clearly illustrate the embodiments or the technical solutions of the present application, the drawings illustrating the embodiments of the present application will be briefly described below. The drawings in the following description merely illustrate some embodiments of the present application. Other drawings may also be obtained by those skilled in the art according to these figures without additional creative work.

FIG. 1 is a structural schematic diagram of a semiconductor laser module provided by an embodiment of the present application.

FIG. 2 is a cross-sectional diagram of the semiconductor laser module shown in FIG. 1 along the P1-P1 direction.

FIG. 3 is a partial diagram of a top view on the semiconductor laser module shown in FIG. 1.

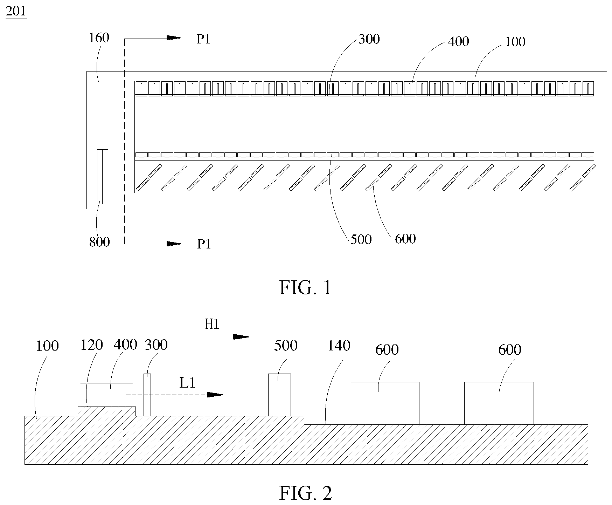

FIG. 1 is another structural schematic diagram of the semiconductor laser module provided by an embodiment of the present application.

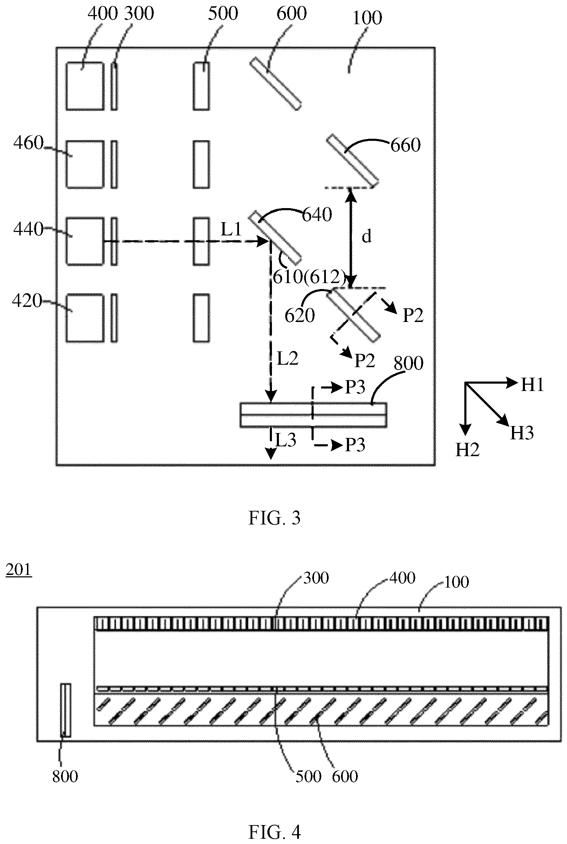

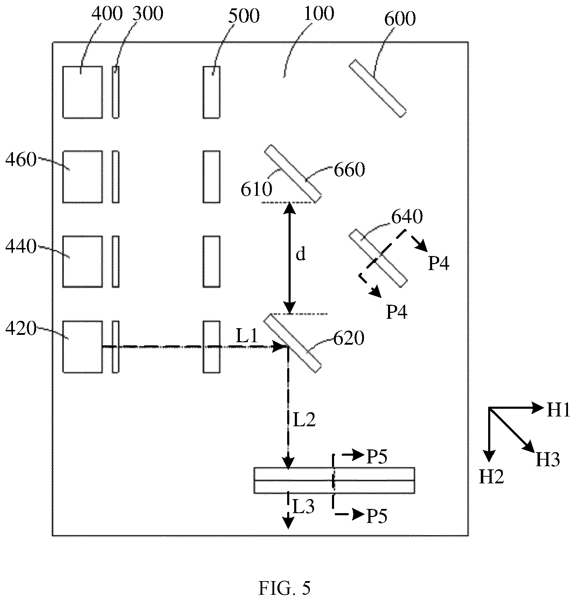

FIG. 5 is a partial diagram of a top view on the semiconductor laser module shown in FIG. 4.

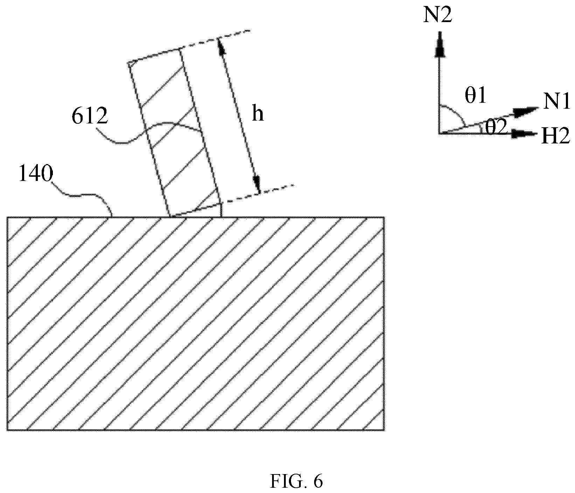

FIG. 6 is a cross-sectional diagram of a light beam reflector and a heat sink base shown in FIG. 3 along the P2-P2 direction and a cross-sectional view of the light beam reflector and the heat sink base shown in FIG. 5 along the P4-P4 direction.

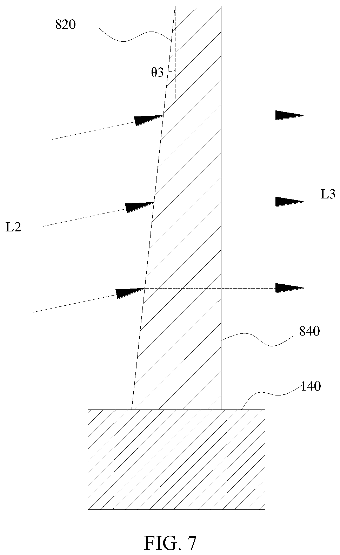

FIG. 7 is a cross-sectional diagram of the light beam reflector and the heat sink base shown in FIG. 3 along the P3-P3 direction and a cross-sectional view of the light beam reflector and the heat sink base shown in FIG. 5 along the P5-P5 direction.

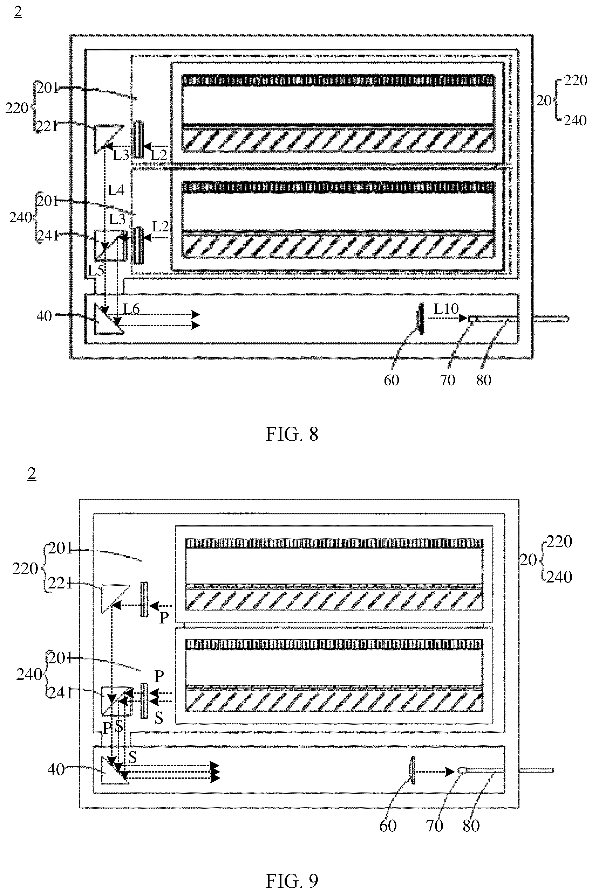

FIG. 8 is a first structural schematic diagram of a semiconductor laser provided by an embodiment of the present application.

FIG. 9 is a light path diagram of the first structural schematic diagram shown in FIG. 8.

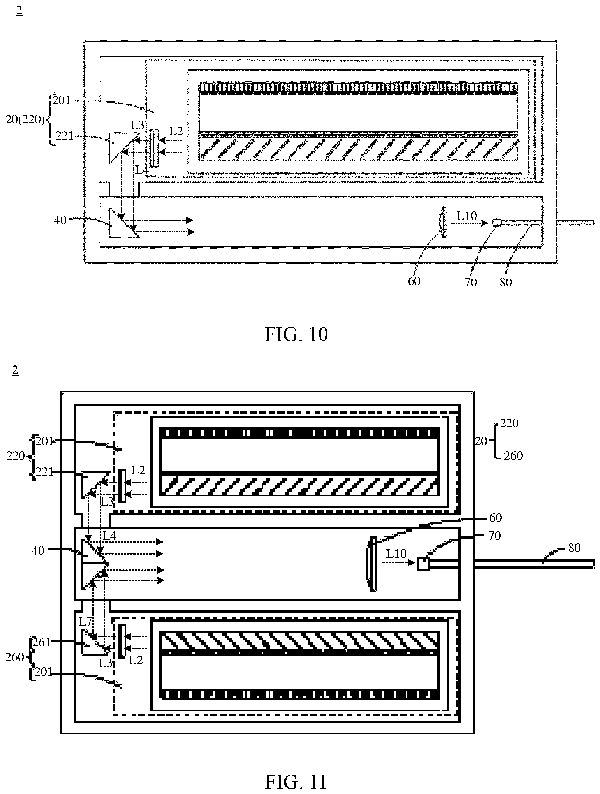

FIG. 10 is a second structural schematic diagram of a semiconductor laser provided by an embodiment of the present application.

FIG. 11 is a third structural schematic diagram of a semiconductor laser provided by an embodiment of the present application.

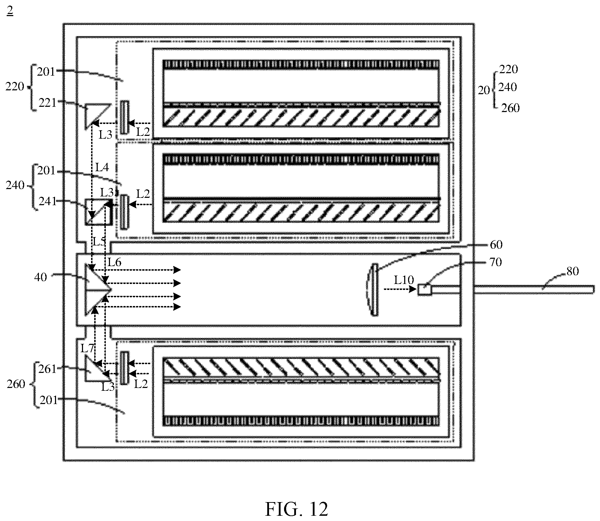

FIG. 12 is a fourth structural schematic diagram of a semiconductor laser provided by an embodiment of the present application.

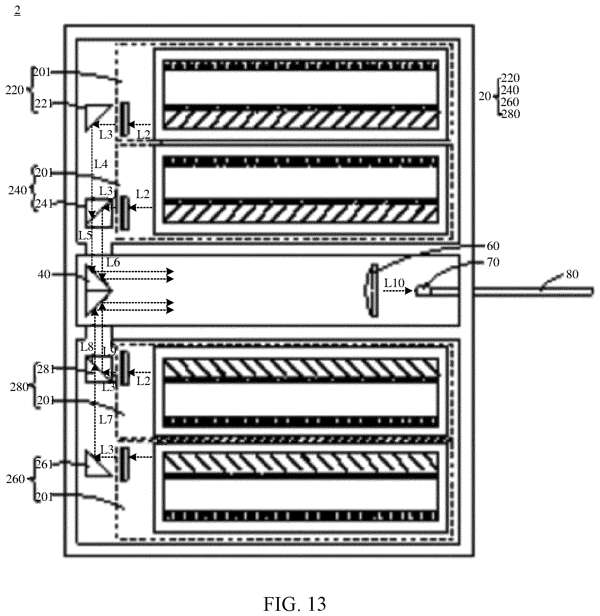

FIG. 13 is a fifth structural schematic diagram of a semiconductor laser provided by an embodiment of the present application.

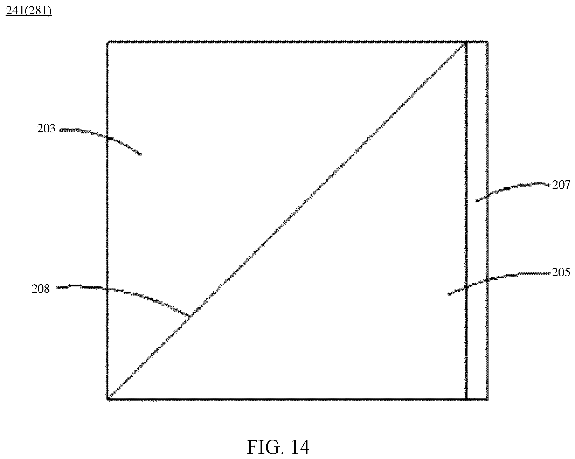

FIG. 14 is a structural representation of a first polarization beam splitter prism shown in FIG. 8, FIG. 12, and FIG. 13 and a second polarization beam splitter prism shown in FIG. 12 and FIG. 13.

## DETAILED DECRIPTION OF THE EMBODIMENTS

The technical solutions in the embodiments of the present application will be clearly and completely described below in conjunction with the drawings in the embodiments of the present application. Apparently, the described embodiments are only some of the embodiments of the present application, not all of them. Based on the embodiments in the present application, all other embodiments obtained by those skilled in the art without making creative efforts belong to the protection scope of this present application.

In the description of the present application, it should be understood that terms "first", "second", "third", "fourth", "fifth", "sixth", "seventh", "seventh", "eight" and "ninth" are used for descriptive purposes only, and should not be understood as indicating or implying relative importance or implicitly indicating the number of indicated technical features.

Referring to FIG. 1-FIG. 3 and FIG. 6-FIG. 7, a semiconductor laser module 201 is provided by an embodiment of the present application and includes a heat sink base 100, a plurality of laser chips 400, a plurality of light beam reflectors 600, and a light beam deflector 800.

The heat sink base 100 includes a first plane 120 and a second plane 140.

The plurality of laser chips 400 are arranged on the first plane 120, and the laser chips 400 are configured to emit a first laser light L1. A propagation direction of the first laser light L1 is the first direction H1.

The plurality of light beam reflectors 600 are arranged on the second plane 140. The beam reflectors 600 correspond to the laser chips 400 one-by-one. A normal direction N2 of the second plane 140 is perpendicular to the first direction H1. The light beam reflector 600 includes a first reflective surface 610. An angle between a normal direction N1 of the first reflective surface 610 and the normal direction N2 of the second plane 140 is a first included angle 01, and the first included angle $\theta1$ is an acute angle. The first reflective surface 610 is configured to reflect the first laser L1 to form a second laser L2.

The light beam deflector 800 is configured to deflect the second laser L2 to form a third laser L3. A propagation direction of the third laser L3 is a second direction H2. The second direction H2 is perpendicular to the first direction H1, and the second direction H2 is perpendicular to the normal direction N2 of the second plane 140.

It can be understood that the semiconductor laser module 201 is arranged on the second plane 140 through the light beam reflector 600 so that a normal line of the first reflective surface 610 and a normal line of the second plane 140 form the acute angle, and that the semiconductor laser module 201 is provided with the light beam deflector 800, so that the first laser L1 is reflected by the first reflective surface 610 to form the second laser L2, and the second laser L2 is deflected by the light beam deflector 800 to form the third laser L3. The propagation direction of the third laser L3 is perpendicular to the propagation direction of the first laser L1 and the normal direction of the second plane 140, so as to realize stepless spatial combination of the first laser L1.

It can be understood that, referring to FIG. 1 and FIG. 2, the first plane 120 is coplanar or parallel to the second plane 140.

It can be understood that, referring to FIG. 1, the heat sink base 100 further includes a third plane 160. The light beam deflector 800 is arranged on the third plane 160. The third plane 160 is coplanar or parallel to the second plane 140.

Exemplarily, the light beam reflector 600 may be a mirror.

It can be understood that, referring to FIG. 3 and FIG. 5, the first reflective surface 610 faces the laser chip 400 and the light beam deflector 800, and a plane where the first reflective surface 610 is located intersects with the second plane 140 to form an intersection line 612. An end of the intersection line 612 close to the laser chip 400 is a first end. An end of the intersection line 612 away from the laser chip 400 is a second end. A direction from the first end to the second end is a third direction H3. An angle between the third direction H3 and the first direction H1 is 45 degrees.

In some embodiments, please refer to FIG.2 and FIG.3, the plurality of laser chips 400 include three laser chips arranged in sequence. The three laser chips 400 are sequentially defined as a first laser chip 420, a second laser chip 440, and a third laser chip 460. The plurality of light beam reflectors 600 include three light beam reflectors 600 arranged in sequence. The three light beam reflectors 600 are sequentially defined as a first light beam reflector 620, a second light beam reflector640, and a third light beam reflector 660. The first light beam reflector 620 corresponds to the first laser chip 420. The second light beam reflector 640 corresponds to the second laser chip 440. Third light beam reflector 660 corresponds to the third laser chip 460.

A distance between the first light beam reflector 620 and the first laser chip 420 is a first distance. A distance between the second light beam reflector 640 and the second laser chip 440 is a second distance. A distance between the third light beam reflector 660 and the third laser chip 460 is a third distance. The third distance is equal to the first distance. The second distance is less than the first distance. The first reflective surface 610 of the first light beam reflector 620 is coplanar or parallel to a first reflective surface 610 of the second light beam reflector 640. The first reflective surface 610 of the first light beam reflector 620 is parallel to the first reflective surface 610 of the third light beam reflector 660.

In some embodiments, please refer to FIG. 4 and FIG. 5, the plurality of laser chips 400 include three laser chips 400 arranged in sequence. The three laser chips 400 are sequentially defined as a first laser chip 420, a second laser chip 440, and a third laser chip 460. The plurality of light beam reflectors 600 include three light beam reflectors 600 arranged in sequence. The three light beam reflectors 600 are sequentially defined as a first light beam reflector 620, a second light beam reflector 640, and a third light beam reflector 660. the first light beam reflector 620 corresponds to the first laser chip 420. The second light beam reflector 640 corresponds to the second laser chip 440. The third light beam reflector 660 corresponds to the third laser chip 460.

A distance between the first light beam reflector 620 and the first laser chip 420 is a first distance. A distance between the second light beam reflector 640 and the second laser chip 440 is a second distance. A distance between the third light beam reflector 660 and the third laser chip 460 is a third distance. The third distance is equal to the first distance. The second distance is greater than the first distance. The first reflective surface 610 of the second light beam reflector 640 is coplanar or parallel to the first reflective surface 610 of the third light beam reflector 660. The first reflective surface 610 of the first light beam reflector 620 is parallel to the first reflective surface 610 of the third light beam reflector.

It can be understood that, referring to FIG. 6 and FIG. 7, a complementary angle of the first included angle θ1 is a second included angle θ2. A value range of an angle of the second included angle θ2 is

$$x > \sin^{-1}\left(\frac{h}{4d}\right)$$

x is the angle of the second included angle θ2. h is a height of the first reflective surface 610. d is a distance between the first light beam reflector 620 and the third light beam reflector 660.

The light beam deflector 800 includes a first mirror surface 820 and a second mirror surface 840 arranged opposite to each other. An included angle between a plane where the first mirror surface 820 is located and a plane where the second mirror surface 840 is located is a third included angle θ3. A value range of an angle of third included angle θ3 is

$$y = \tan^{-1}\left(\frac{2\sin x \cos x}{n - \cos^2 x + \sin^2 x}\right)$$

y is the angle of the third included angle θ3. x is the angle of the second included angle θ2. n is a refractive index of the wedge prism.

It can be understood that h is the height of the first reflective surface 610, specifically, the distance between an end of the first reflective surface 610 away from the second plane 140 and an end of the first reflective surface 610 close to the second plane 140.

In some embodiments, referring to FIG. 1 and FIG. 2, the semiconductor laser module 201 further includes a plurality of fast-axis collimators 300 and a plurality of slow-axis collimators 500.

The fast-axis collimators 300 correspond to the laser chips 400 one-by-one, and the fast-axis collimators 300 are configured to collimate the first laser L1 emitted by a corresponding laser chip 400 in a fast-axis direction.

The slow-axis collimators 500 correspond to the fast-axis collimators 300 one-by one, and the slow-axis collimators 500 are configured to collimate the first laser L1 collimated by a corresponding fast-axis collimator 300 in a fast-axis direction.

Exemplarily, the fast-axis collimator 300 may be a fast-axis collimating mirror. The slow-axis collimator 500 is a slow-axis collimating mirror.

Referring to FIG. 8 to FIG. 13, a semiconductor laser 2 is also provided by an embodiment of the present application and includes at least one optical path module 20, a second reflector 40, a focusing lens 60, and an optical fiber 80.

The optical path module is a semiconductor laser module 201.

The second reflector 40 is configured to receive all laser emitted by the optical path module and reflect the laser to the focusing lens 60. The focusing lens 60 is configured to focus all the laser to form a combined laser beam L10. The combined laser beam L10 enters the optical fiber 80 and then outputs through the optical fiber 80.

In some embodiments, please refer to FIG.8 and FIG. 9, the at least one optical path module 20 includes a first optical path module 220 and a second optical path module.

A first optical path module 220 includes the semiconductor laser module 201 and a third reflector 221. The second optical path module 240 includes the semiconductor laser module 201 and a first polarization beam splitting prism 241.

The third reflector 221 is configured to reflect the third laser L3 emitted by the semiconductor laser module 201 in the first optical path module 220 to form a fourth laser L4. The first polarization beam splitting prism 241 is configured to transmit the fourth laser L4 to form a fifth laser L5 and is configured to reflect the third laser L3 emitted by the semiconductor laser module 201 in the second optical path module 240 to form a sixth laser L6.

Propagation directions of the fifth laser L5 and the sixth laser L6 are in a same direction. The fifth laser L5 and the sixth laser L6 are reflected by the second reflector 40 to the focusing lens 60 and then focused by the focusing lens 60 to form the combined laser beam L10, and the combined beam laser beam L10 enters the optical fiber 80 and then outputs through the optical fiber 80.

In some embodiments, please refer to FIG. 10, the at least one optical path module 20 includes a first optical path module 220. The first optical path module 220 includes the semiconductor laser module 201 and a third reflector 221.

The third reflector 221 is configured to reflect the third laser L3 emitted by the semiconductor laser module 201 in the first optical path module 220 to form a fourth laser L4. The fourth laser L4 is reflected by the second reflector 40 to the focusing lens 60 and then focused by the focusing lens 60 to form the combined laser beam L10. The combined laser beam L10 enters the optical fiber 80 and then outputs through the optical fiber 80.

In some embodiments, please refer to FIG. 11, the at least one optical path module 30 includes a first optical path module 220 and a third optical path module 260. the first optical path module 220 includes the semiconductor laser module 201 and a third reflector 221. the third optical path module 260 includes the semiconductor laser module 201 and a fourth reflector 261.

The third reflector 221 is configured to reflect the third laser L3 emitted by the semiconductor laser module 201 in the first optical path module 220 to form a fourth laser L4. The fourth reflector 261 is configured to reflect the third laser L3 emitted by the semiconductor laser module 201 in the third optical path module 260 to form a seventh laser L7.

Propagation directions of the fourth laser L4 and the seventh laser L7 are in opposite directions. The fourth laser L4 and the seventh laser L7 are reflected by the second reflector 40 to the focusing lens 60 and then focused by the focusing lens 60 to form the combined laser beam L10, and the combined beam laser beam L10 enters the optical fiber 80 and then outputs through the optical fiber 80.

In some embodiments, please refer to FIG. 12, the at least one optical path module 20 includes a first optical path module 220, a second optical path module 240 and a third optical path module 260.

The first optical path module 220 includes the semiconductor laser module 201 and a third reflector 221. The second optical path module 240 includes the semiconductor laser module 201 and a first polarization beam splitting prism 241. The third optical path module 260 includes the semiconductor laser module 201 and a fourth reflector 261.

The third reflector 221 is configured to reflect the third laser L3 emitted by the semiconductor laser module 201 in the first optical path module 220 to form a fourth laser L4. The first polarization beam splitting prism 241 is configured to transmit the fourth laser L4 to form a fifth laser L5 and is configured to reflect the third laser L3 emitted by the semiconductor laser module 201 in the second optical path module 240 to form a sixth laser L6. The fourth reflector 261 is configured to reflect the third laser L3 emitted by the semiconductor laser module 201 in the third optical path module 260 to form a seventh laser L7.

Propagation directions of the fifth laser L5 and the sixth laser L6 are in a same direction. A propagation direction of the seventh laser L7 is opposite to propagation directions of the fifth laser L5 and the sixth laser L6. The fifth laser L5, the sixth laser L6 and the seventh laser L7 are reflected by the second reflector 40 to the focusing lens 60 and then focused by the focusing lens 60 to form the combined laser beam L10, and the combined beam laser beam L10 enters the optical fiber 80 and then outputs through the optical fiber 80.

In some embodiments, please refer to FIG. 13, the at least one optical path module 20 includes a first optical path module 220, a second optical path module 240, a third optical path module 260, and a fourth optical path module 280.

The first optical path module 220 includes the semiconductor laser module 201 and a third reflector 221. The second optical path module 240 includes the semiconductor laser module 201 and a first polarization beam splitting prism 241. The third optical path module 260 includes the semiconductor laser module 201 and a fourth reflector 261. The fourth optical path module 280 includes the semiconductor laser module 201 and a second polarization beam splitting prism 281.

The third reflector 221 is configured to reflect the third laser L3 emitted by the semiconductor laser module 201 in the first optical path module 220 to form a fourth laser L4. The first polarization beam splitting prism 241 is configured to transmit the fourth laser L4 to form a fifth laser L5, and is configured to reflect the third laser L3 emitted by the semiconductor laser module 201 in the second optical path module 240 to form a sixth laser L6. The fourth reflector 261 is configured to reflect the third laser L3 emitted by the semiconductor laser module 201 in the third optical path module 260 to form a seventh laser L7. The second polarization beam splitting prism 281 is configured to transmit the seventh laser L7 to form an eighth laser L8, and is configured to reflect the third laser L3 emitted by the semiconductor laser module 201 in the fourth optical path module 280 to form a ninth laser L9.

Propagation directions of the fifth laser L5 and the sixth laser L6 are a same direction. Propagation directions of the eight laser L8 and the ninth laser L9 are a same direction. Propagation directions of the fifth laser L5 and the sixth laser L6 are opposite to propagation directions of the eight laser L8 and ninth laser L9. The fifth laser L5, the sixth laser L6, the eighth laser L8, and the ninth laser L9 are reflected by the second reflector 40 to the focusing lens 60, and then focused by the focusing lens 60 to form the combined laser beam L10. The combined laser beam L10 enters the optical fiber 80 and then outputs through the optical fiber 80.

In some embodiments, referring to FIG. 8 to FIG. 13, the semiconductor laser 2 further includes an optical fiber end cap 70. The optical fiber end cap 70 is arranged at an end of the fiber 80 close to the focusing lens 60.

It can be understood that, referring to FIG. 8 to FIG. 10, the second reflector 40 may include a reflective surface. Exemplarily, the second reflector 40 is a right angle mirror. Referring to FIG. 11 to FIG. 13, the second reflector 40 may also include two mutually perpendicular reflecting surfaces. Exemplarily, the second reflector 40 is formed by splicing two right-angle reflectors, and the reflective surface of one of the right-angle reflectors is perpendicular to the reflective surface of another right-angle reflector.

It can be understood that, referring to the first polarization beam splitting prism 241 in FIG. 8, FIG. 9 and FIG. 12 to FIG. 13, structures of the second polarization beam splitting prism 281 are shown in FIG. 14. The first polarization beam splitting prism 241 and the second polarization beam splitting prism 281 have same structures, including a first prism 203, a second prism 205, a half-wave plate 207, and a polarization beam splitting coating 208. The polarization splitting coating 208 is adhesively connected between the first prism 203 and the second prism 205. The half-wave plate 207 is glued to an outer wall of the second prism 205. Referring to FIG. 9 and FIG. 14, the first polarization beam splitting prism 241 and the second polarization beam splitting prism 281 are used to allow P light to pass and reflect S light. It can be understood that, in FIG. 9, the letter P is used to represent the P light, and the letter S is used to represent the S light.

It can be understood that in the semiconductor laser 2 shown in FIG. 8- FIG. 9, the laser chip 400 of the first optical path module 220 can be configured to emit the P light, and the laser chip 400 of the second optical path module 240 can be configured to emit the P light and/or the S light. In the semiconductor laser 2 shown in FIG. 10, the laser chip 400 of the first optical path module 220 may be configured to emit the P light and/or the S light. In the semiconductor laser 2 shown in FIG. 11, the laser chip 400 of the first optical path module 220 can be configured to emit the P light and/or the S light. The laser chip 400 of the third optical path module 260 can be configured to emit the P light and/or the S light. In the semiconductor laser 2 shown in FIG. 12, the laser chip 400 of the first optical path module 220 can be configured to emit the P light, the laser chip 400 of the second optical path module 240 can be configured to emit the P light and/or the S light, and the third laser chip 400 of the optical path module 260 may be configured to emit the P light and/or the S light. In the semiconductor laser 2 shown in FIG. 13, the laser chip 400 of the first optical path module 220 can be configured to emit the P light, the laser chip 400 of the second optical path module 240 can be configured to emit the P light and/or the S light, the third laser chip 400 of the optical path module 260 may be configured to emit the P light, and the laser chip 400 of the fourth optical path module 280 may be configured to emit the P light and/or the S light.

The semiconductor laser module provided by the embodiment of the present application and the semiconductor laser have been described in detail above, applied specific examples herein to explain the principle and implementation of the present application, and the description of the above embodiment is only used to help understand the method of this present application and its core idea; at the same time, for those skilled in the art, according to the idea of this present application, there will be changes in the specific implementation and scope of present application. In summary, the content of this specification should not be understood as a limitation on this present application.

## Claims

1. A semiconductor laser module, comprising:

   a heat sink base comprising a first plane and a second plane;
   a plurality of laser chips arranged on the first plane, wherein the laser chip is configured to emit a first laser, and a propagation direction of the first laser is a first direction; and
   a plurality of light beam reflectors arranged on the second plane, wherein the light beam reflectors correspond to the laser chips one-by-one, a normal direction of the second plane is perpendicular to the first direction, the light beam reflector comprises a first reflective surface, an angle between a normal direction of the first reflective surface and the normal direction of the second plane is a first included angle, the first included angle is an acute angle, and the first reflective surface is configured to reflect the first laser to form a second laser; and
   a light beam deflector configured to deflect the second laser to form a third laser, wherein a propagation direction of the third laser is a second direction, the second direction is perpendicular to the first direction, and the second direction is perpendicular to the normal direction of the second plane.

2. The semiconductor laser module according to claim 1, wherein the first reflective surface faces the laser chip and the light beam deflector, a plane where the first reflective surface is located intersects with the second plane in a form of an intersection line, an end of the intersection line close to the laser chip is a first end, an end of the intersection line away from the laser chip is a second end, a direction from the first end to the second end is a third direction, and an angle between the third direction and the first direction is 45 degrees.

3. The semiconductor laser module according to claim 2, wherein the plurality of laser chips comprise three laser chips arranged in sequence, and the three laser chips are sequentially defined as a first laser chip, a second laser chip, and a third laser chip; the plurality of light beam reflectors comprise three light beam reflectors arranged in sequence, and the three light beam reflectors are sequentially defined as a first light beam reflector, a second light beam reflector, and a third light beam reflector; the first light beam reflector corresponds to the first laser chip, the second light beam reflector corresponds to the second laser chip, and the third light beam reflector corresponds to the third laser chip; and
   wherein a distance between the first light beam reflector and the first laser chip is a first distance, a distance between the second light beam reflector and the second laser chip is a second distance, and a distance between the third light beam reflector and the third laser chip is a third distance, the third distance is equal to the first distance, the second distance is less than the first distance, a first reflective surface of the first light beam reflector is coplanar or parallel to a first reflective surface of the second light beam reflector, and the first reflective surface of the first light beam reflector is parallel to a first reflective surface of the third light beam reflector.

4. The semiconductor laser module according to claim 2, wherein the plurality of laser chips comprise three laser chips arranged in sequence, and the three laser chips are sequentially defined as a first laser chip, a second laser chip, and a third laser chip; the plurality of light beam reflectors comprise three light beam reflectors arranged in sequence, and the three light beam reflectors are sequentially defined as a first light beam reflector, a second light beam reflector, and a third light beam reflector; the first light beam reflector corresponds to the first laser chip, the second light beam reflector corresponds to the second laser chip, and the third light beam reflector corresponds to the third laser chip; and
   wherein a distance between the first light beam reflector and the first laser chip is a first distance, a distance between the second light beam reflector and the second laser chip is a second distance, and a distance between the third light beam reflector and the third laser chip is a third distance, the third distance is equal to the first distance, the second distance is greater than the first distance, a first reflective surface of the second light beam reflector is coplanar or parallel to a first reflective surface of the third light beam reflector, and the first reflective surface of the first light beam reflector is parallel to a first reflective surface of the third light beam reflector.

5. The semiconductor laser module according to claim 3, wherein the light beam deflector is a wedge prism.

6. The semiconductor laser module according to claim 5, wherein a complementary angle of the first included angle is a second included angle; a value range of an angle of the second included angle is

$$x > \sin^{-1}\left(\frac{h}{4d}\right);$$

   wherein x is the angle of the second included angle; h is a height of the first reflective surface; d is a distance between the first light beam reflector and the third light beam reflector; and the light beam deflector comprises a first mirror surface and a second mirror surface arranged opposite to each other; a plane where the first mirror surface is located and a plane where the second mirror surface is located is a third included angle; a value range of an angle of third included angle is

$$y = \tan^{-1}\left( \frac{2 \sin x \cos x}{n - \cos^2 x + \sin^2 x} \right);$$

wherein y is the angle of the third included angle, x is the angle of the second included angle, and n is a refractive index of the wedge prism.

7. The semiconductor laser module according to claim 6, wherein the semiconductor laser module further comprises:

a plurality of fast-axis collimators, wherein the fast-axis collimators correspond to the laser chips one-by-one, and the fast-axis collimators are configured to collimate the first laser emitted by a corresponding laser chip in a fast-axis direction; and

a plurality of slow-axis collimators, wherein the slow-axis collimators correspond to the fast-axis collimators, and the slow-axis collimators are configured to collimate the first laser collimated by a corresponding fast-axis collimator in a fast-axis direction.

8. A semiconductor laser, comprising:

at least one optical path module, a second reflector, a focusing lens, and an optical fiber;

wherein the optical path module comprises a semiconductor laser module, and the semiconductor laser module comprises:

a heat sink base comprising a first plane and a second plane;

a plurality of laser chips arranged on the first plane, wherein the laser chip is configured to emit a first laser, and a propagation direction of the first laser is a first direction; and

a plurality of light beam reflectors arranged on the second plane, the light beam reflectors correspond to the laser chips one-by-one, a normal direction of the second plane is perpendicular to the first direction, the light beam reflector comprises first reflective surface, an angle between a normal direction of the first reflective surfaces and the normal direction of the second plane is a first included angle, and the first included angle is an acute angle, and the first reflective surface is configured to reflect the first laser to form a second laser; and

a light beam deflector configured to deflect the second laser to form a third laser, a propagation direction of the third laser is a second direction, the second direction is perpendicular to the first direction, and the second direction is perpendicular to the normal direction of the second plane;

wherein the second reflector is configured to receive all laser emitted by the optical path module and reflect the laser to the focusing lens, the focusing lens is configured to focus all the laser to form a combined laser beam, and the combined laser beam enters the optical fiber and then outputs through the optical fiber.

9. The semiconductor laser according to claim 8, wherein the first reflective surface faces the laser chips and the light beam deflector, and a plane where the first reflective surface is located intersects with the second plane to form an intersection line, an end of the intersection line close to the laser chips is a first end, and an end of the intersection line away from the laser chips is a second end; a direction from the first end to the second end is a third direction, and an angle between the third direction and the first direction is 45 degrees.

10. The semiconductor laser according to claim 9, wherein the plurality of laser chips comprise three laser chips arranged in sequence, and the three laser chips are sequentially defined as a first laser chip, a second laser chip, and a third laser chip; the plurality of light beam reflectors comprise three light beam reflectors arranged in sequence, and the three light beam reflectors are sequentially defined as a first light beam reflector, a second light beam reflector and a third light beam reflector; the first light beam reflector corresponds to the first laser chip, the second light beam reflector corresponds to the second laser chip, and the third light beam reflector corresponds to the third laser chip; and

wherein a distance between the first light beam reflector and the first laser chip is a first distance, a distance between the second light beam reflector and the second laser chip is a second distance, and a distance between the third light beam reflector and the third laser chip is a third distance, the third distance is equal to the first distance, the second distance is less than the first distance, a first reflective surface of the first light beam reflector is coplanar or parallel to a first reflective surface of the second light beam reflector, and the first reflective surface of the first light beam reflector is parallel to a first reflective surface of the third light beam reflector.

11. The semiconductor laser according to claim 9, wherein the plurality of laser chips comprise three laser chips arranged in sequence, and the three laser chips are sequentially defined as a first laser chip, a second laser chip, and a third laser chip; the plurality of light beam reflectors comprise three light beam reflectors arranged in sequence, and the three light beam reflectors are sequentially defined as a first light beam reflector, a second light beam reflector and a third light beam reflector; the first light beam reflector corresponds to the first laser chip, the second light beam reflector corresponds to the second laser chip, and the third light beam reflector corresponds to the third laser chip; and
wherein a distance between the first light beam reflector and the first laser chip is a first distance, a distance between the second light beam reflector and the second laser chip is a second distance, and a distance between the third light beam reflector and the third laser chip is a third distance, the third distance is equal to the first distance, the second distance is greater than the first distance, a first reflective surface of the second light beam reflector is coplanar or parallel to a first reflective surface of the third light beam reflector, and the first reflective surface of the first light beam reflector is parallel to a first reflective surface of the third light beam reflector.

12. The semiconductor laser according to claim 10, wherein the light beam deflector is the wedge prism.

13. The semiconductor laser according to claim 12, wherein a complementary angle of the first included angle is a second included angle; a value range of an angle of the second included angle is

$$x > \sin^{-1}\left(\frac{h}{4d}\right)$$
.

wherein x is the angle of the second included angle, h is a height of the first reflective surface, and d is a distance between the first light beam reflector and the third light beam reflector; and

$$y = \tan^{-1}\left(\frac{2\sin x \cos x}{n - \cos^2 x + \sin^2 x}\right)$$
; the light beam deflector comprises a first mirror surface and a second mirror surface arranged opposite to each other; a plane where the first mirror surface is located and a plane where the second mirror surface is located is a third included angle; a value range of an angle of third included angle

$$y = \tan^{-1}\left(\frac{2\sin x \cos x}{n - \cos^2 x + \sin^2 x}\right)$$
is
;
wherein y is the angle of the third included angle; x is the angle of the second included angle; n is a refractive index of the wedge prism.

14. The semiconductor laser according to claim 13, wherein the semiconductor laser module further comprises:

a plurality of fast-axis collimators, wherein the fast-axis collimators correspond to the laser chips one-by-one; and the fast-axis collimators are configured to collimate the first laser emitted by a corresponding laser chip in a fast-axis direction; and
a plurality of slow-axis collimators, wherein the slow-axis collimators correspond to the fast-axis collimators, and the slow-axis collimators are configured to collimate the first laser collimated by a corresponding fast-axis collimator in a fast-axis direction.

15. The semiconductor laser according to claim 8, wherein the at least one optical path module comprises:

a first optical path module comprising the semiconductor laser module and a third reflector;
a second optical path module comprising the semiconductor laser module and a first polarization beam splitting prism; and
wherein the third reflector is configured to reflect the third laser emitted by the semiconductor laser module in the first optical path module to form a fourth laser; the first polarization beam splitting prism is configured to transmit the fourth laser to form a fifth laser and is configured to reflect the third laser emitted by the semiconductor laser module in the second optical path module to form a sixth laser; and propagation directions of the fifth laser and the sixth laser are in a same direction; the fifth laser and the sixth laser are reflected by the second reflector to the focusing lens and then focused by the focusing lens to form the combined laser beam, and the combined laser beam enters the optical fiber and then outputs through the optical fiber.

16. The semiconductor laser according to claim 8, wherein the at least one optical path module comprises:

the semiconductor laser module;
a third reflector; and
wherein the third reflector is configured to reflect the third laser emitted by the semiconductor laser module to form a fourth laser; and the fourth laser is reflected by the second reflector to the focusing lens and then focused by the focusing lens to form the combined laser beam, and the combined laser beam enters the optical fiber and then outputs through the optical fiber.

17. The semiconductor laser according to claim 8, wherein the at least one optical path module comprises:

a first optical path module comprising the semiconductor laser module and a third reflector;
a third optical path module comprising the semiconductor laser module and a fourth reflector; and
wherein the third reflector is configured to reflect the third laser emitted by the semiconductor laser module in the first optical path module to form a fourth laser; the fourth reflector is configured to reflect the third laser emitted by the semiconductor laser module in the third optical path module to form a seventh laser; propagation directions of the fourth laser and the seventh laser are in opposite directions; and the fourth laser and the seventh laser are reflected by the second reflector to the focusing lens and then focused by the focusing lens to form the combined laser beam, and the combined beam laser beam enters the optical fiber and then outputs through the optical fiber.

18. The semiconductor laser according to claim 8, wherein the at least one optical path module comprises:

a first optical path module comprising the semiconductor laser module and a third reflector;
a second optical path module comprising the semiconductor laser module and a first polarization beam splitting prism; and
a third optical path module comprising the semiconductor laser module and a fourth reflector; and
wherein the third reflector is configured to reflect the third laser emitted by the semiconductor laser module in the first optical path module to form a fourth laser; the first polarization beam splitting prism is configured to transmit the fourth laser to form a fifth laser and is configured to reflect the third laser emitted by the semiconductor laser module in the second optical path module to form a sixth laser; and the fourth reflector is configured to reflect the third laser emitted by the semiconductor laser module in the third optical path module to form a seventh laser; and propagation directions of the fifth laser and the sixth laser are in a same direction; a propagation direction of the seventh laser is opposite to propagation directions of the fifth laser and the sixth laser; and the fifth laser, the sixth laser and the seventh laser are reflected by the second reflector to the focusing lens and then focused by the focusing lens to form the combined laser beam, and the combined beam laser beam enters the optical fiber and then outputs through the optical fiber.

19. The semiconductor laser according to claim 8, wherein the at least one optical path module comprises:

a first optical path module comprising the semiconductor laser module and a third reflector;
a second optical path module comprising the semiconductor laser module and a first polarization beam splitting prism; and
a third optical path module comprising the semiconductor laser module and a fourth reflector;
a fourth optical path module comprising the semiconductor laser module and a second polarization beam splitting prism; and
wherein the third reflector is configured to reflect the third laser emitted by the semiconductor laser module in the first optical path module to form a fourth laser; the first polarization beam splitting prism is configured to transmit the fourth laser to form a fifth laser, and is configured to reflect the third laser emitted by the semiconductor laser module in the second optical path module to form a sixth laser; and the fourth reflector is configured to reflect the third laser emitted by the semiconductor laser module in the third optical path module to form a seventh laser; the second polarization beam splitting prism is configured to transmit the seventh laser to form an eighth laser, and is configured to reflect the third laser emitted by the semiconductor laser module in the fourth optical path module to form a ninth laser; propagation directions of the fifth laser and the sixth laser are a same direction; propagation directions of the eight laser and the ninth laser are a same direction; propagation directions of the fifth laser and the sixth laser are opposite to propagation directions of the eight laser and ninth laser; and the fifth laser, the sixth laser, the eighth laser, and the ninth laser are reflected by the second reflector to the focusing lens, and then focused by the focusing lens to form the combined laser beam, the combined laser beam enters the optical fiber and then outputs through the optical fiber.

20. The semiconductor laser according to claim 8, wherein the semiconductor laser further comprises: an optical fiber end cap, the optical fiber end cap is arranged at an end of the optical fiber close to the focusing lens; and the combined laser beam enters the optical fiber through the optical fiber end cap and outputs through the optical fiber.

201

160    P1    300    400    100

800    P1    500    600

FIG. 1

H1

100    120    400    300    L1    500    140    600    600

FIG. 2

FIG. 3

FIG. 4

FIG. 5

N2

θ1

N1

θ2

H2

612

140

h

FIG. 6

820

θ3

L2

L3

840

140

FIG. 7

FIG. 8

FIG. 9

FIG. 10

FIG. 11

FIG. 12

FIG. 13

241(281)

FIG. 14

## INTERNATIONAL SEARCH REPORT

| | International application No. |
|---|---|
| | **PCT/CN2022/118219** |

**A. CLASSIFICATION OF SUBJECT MATTER**

H01S 5/40(2006.01)i; H01S 5/02255(2021.01)i; H01S 5/02315(2021.01)i; H01S 5/02326(2021.01)i; H01S 5/024(2006.01)i

According to International Patent Classification (IPC) or to both national classification and IPC

**B. FIELDS SEARCHED**

Minimum documentation searched (classification system followed by classification symbols)

H01S

Documentation searched other than minimum documentation to the extent that such documents are included in the fields searched

Electronic data base consulted during the international search (name of data base and, where practicable, search terms used)

CNPAT; CNKI; WPI; EPODOC: 半导体激光器, 激光, 台阶, 平面, 反射, 夹角, 倾角, 倾斜, 偏折, 转折, 棱镜, 光纤; LD, laser, step, plane, reflect+, angle, incline, tilt+, slope, prism, fiber

**C. DOCUMENTS CONSIDERED TO BE RELEVANT**

| Category* | Citation of document, with indication, where appropriate, of the relevant passages | Relevant to claim No. |
|---|---|---|
| PX | CN 114069390 A (WUHAN RAYCUS FIBER LASER TECHNOLOGIES CO., LTD.) 18 February 2022 (2022-02-18) <br> description, paragraphs [0024]-[0069], and figures 1-14 | 1-20 |
| X | CN 214478427 U (WUHAN RAYCUS FIBER LASER TECHNOLOGIES CO., LTD.) 22 October 2021 (2021-10-22) <br> description, paragraphs [0053]-[0090], and figures 1-6 | 1-14, 20 |
| Y | CN 214478427 U (WUHAN RAYCUS FIBER LASER TECHNOLOGIES CO., LTD.) 22 October 2021 (2021-10-22) <br> description, paragraphs [0053]-[0090], and figures 1-6 | 15-19 |
| Y | CN 108885349 A (NLIGHT INC.) 23 November 2018 (2018-11-23) <br> description, paragraphs [0041]-[0059], and figures 1A-11 | 15-19 |
| A | CN 104979749 A (ANSHAN WONDER LIGHT LASER TECHNOLOGY CO., LTD.) 14 October 2015 (2015-10-14) <br> entire document | 1-20 |
| A | CN 108241193 A (BEIJING RECI LASER TECHNOLONGY CO., LTD.) 03 July 2018 (2018-07-03) <br> entire document | 1-20 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **03 November 2022** | **25 November 2022** |

| Name and mailing address of the ISA/CN | Authorized officer |
|---|---|
| **China National Intellectual Property Administration (ISA/CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

| | International application No. |
|---|---|
| | **PCT/CN2022/118219** |

### C. DOCUMENTS CONSIDERED TO BE RELEVANT

| Category* | Citation of document, with indication, where appropriate, of the relevant passages | Relevant to claim No. |
|---|---|---|
| A | CN 102401949 A (BEIJING UNIVERSITY OF TECHNOLOGY) 04 April 2012 (2012-04-04)<br>entire document | 1-20 |
| A | JP H0798402 A (NIPPON STEEL CORP.) 11 April 1995 (1995-04-11)<br>entire document | 1-20 |

Form PCT/ISA/210 (second sheet) (January 2015)

International application No.

**PCT/CN2022/118219**

| Patent document cited in search report | | | Publication date (day/month/year) | Patent family member(s) | | | Publication date (day/month/year) |
|---|---|---|---|---|---|---|---|
| CN | 114069390 | A | 18 February 2022 | CN | 114069390 | B | 19 April 2022 |
| CN | 214478427 | U | 22 October 2021 | | None | | |
| CN | 108885349 | A | 23 November 2018 | KR | 20180114121 | A | 17 October 2018 |
| | | | | WO | 2017143089 | A1 | 24 August 2017 |
| | | | | EP | 3417340 | A1 | 26 December 2018 |
| | | | | US | 2017235057 | A1 | 17 August 2017 |
| | | | | US | 2019212497 | A1 | 11 July 2019 |
| | | | | US | 10261261 | B2 | 16 April 2019 |
| | | | | KR | 102107159 | B1 | 07 May 2020 |
| CN | 104979749 | A | 14 October 2015 | CN | 104979749 | B | 28 November 2017 |
| CN | 108241193 | A | 03 July 2018 | | None | | |
| CN | 102401949 | A | 04 April 2012 | | None | | |
| JP | H0798402 | A | 11 April 1995 | US | 5513201 | A | 30 April 1996 |
| | | | | JP | 3071360 | B2 | 31 July 2000 |

Form PCT/ISA/210 (patent family annex) (January 2015)